# EUROPÄISCHE PATENTSCHRIFT

(11) **EP 2 107 577 B1**
(45) Veröffentlichungstag und Bekanntmachung des Hinweises auf die Patenterteilung: **19.10.2016**
(21) Anmeldenummer: 09004651.7
(22) Anmeldetag: 31.03.2009
(51) Int. Cl.: H01F 17/00, H01F 17/04, H01F 27/28, H01F 41/04, H05K 1/18, H05K 3/46

(54) **Induktionsbauteil und Verfahren zu seiner Herstellung**
Inductive component and method for its production
Composant inductif et procédé de sa fabrication

(30) Priorität: 31.03.2008 DE 102008017303; 22.08.2008 EP 08162811
(43) Veröffentlichungstag der Anmeldung: 07.10.2009
(73) Patentinhaber: Würth Elektronik Rot am See GmbH & Co. KG, 74585 Rot am See (DE)
(72) Erfinder: Kostelnik, Jan, Dr., 74592 Kirchberg (DE)
(74) Vertreter: Patentanwälte Ruff, Wilhelm, Beier, Dauster & Partner mbB

(56) Entgegenhaltungen:
- WO-A-98/56016
- DE-A1- 10 154 833
- US-A- 6 148 500
- US-A1- 2003 080 845

## Beschreibung

Die Erfindung betrifft ein Induktionsbauteil mit mindestens einer, vorzugsweise mehreren Spulen. Derartige Induktionsbauteile werden in der Elektronik benötigt. Sie werden dabei in Zusammenhang mit Leiterplatten verwendet, mit deren Leiterbahnen sie elektrisch verbunden werden müssen.

Es ist bereits ein Induktionsbauteil bekannt (US 6662431). Dieses Induktionsbauteil hat ein Gehäuse, das kastenförmig ausgebildet ist und eine offene der Leiterplatte zugewandte Unterseite aufweist. Die Stirnenden des Gehäuses sind höher als die Seitenwände, so dass die Stirnenden bei der Montage des Bauteils auf der Leiterplatte aufliegen können. Die Anschlusselemente des Gehäuses sind in den Seitenwänden eingeformt, wobei ein Schenkel aus den Kanten der Seitenwände herausragt. Die Enden der Spulenwindungen sind um den herausragenden Schenkel herum gewickelt. Auf diese Weise erfolgt eine Verbindung der Spulenwindungen mit den Anschlusselementen des Gehäuses. Die Anschlusselemente des Gehäuses dienen dazu, die Spulen mit den Leiterbahnen der Leiterplatte zu verbinden.

### (Beginn einer Einfügung)

Es ist bereits ein Verfahren zum Herstellen von ebenen Induktionsbauteilen bekannt, bei dem in eine Leiterplatte parallele langgestreckte Kanäle zur Aufnahme von Magnetkernmaterial und zwischen diesen angeordnete parallele Kanäle zur Aufnahme von leitendem Material zur Bildung von Windungen eingebracht werden (US 2003/0080845 A1).

Ebenfalls bekannt ist eine induktives Bauelement mit einem Magnetkern und Leiterstreifen, die durch ein Leiterplattensubstrat verlaufen und Teile der Spulenwicklungen bilden (WO 98/56016).

### (Ende der Einfügung)

Der Erfindung liegt die Aufgabe zu Grunde, ein Induktionsbauteil mit mindestens einer Spule zu schaffen, das sich mit geringem Aufwand und wenigen Fehlermöglichkeiten herstellen lässt und sich zur Verbindung mit Leiterbahnen von Leiterplatten besonders gut geeignet.

Zur Lösung dieser Aufgabe schlägt die Erfindung ein Induktionsbauteil mit den im Anspruch 1 genannten Merkmalen vor. Die Erfindung schlägt ebenfalls ein Verfahren zur Herstellung eines solchen Bauteils vor. Weiterbildungen der Erfindung sind Gegenstand der jeweiligen abhängigen Patentansprüche.

Dieses von der Erfindung vorgeschlagene Induktionsbauteil enthält also die mindestens eine Spule in einem Hohlraum der Leiterplatte beziehungsweise eines Stücks Leiterplatte. Damit kann sowohl bei der Herstellung des Induktionsbauteils als auch bei der weiteren Verwendung des Induktionsbauteils auf alle bei der Herstellung und Handhabung von Leiterplatten üblichen, bekannten und bewährten Methoden und Vorgängen zurückgegriffen werden. Bei dem Bauteil handelt es sich also um ein Stück Leiterplatte.

Zur Verbindung der Spulenwindungen mit den Leiterbahnen der Leiterplatte kann vorgesehen sein, dass die Windungsenden oder Anzapfungen der Windungen mit durch die Leiterplatte hindurch geführten Kontaktmitteln oder Vias verlötet sind.

Bei der mindestens einen Spule kann es sich um eine gewickelte Drahtspule oder auch um eine Faltflex- Spule handeln.

Ebenfalls möglich ist es, eine Spule als Planarspule herzustellen.

Auf die Faltflex Spule kann auch ein Magnet aufgedruckt werden.

Als besonders sinnvoll hat es sich herausgestellt, wenn dieses Induktionsbauteil nicht nur eine oder mehrere Spulen enthält, sondern weitere für bestimmte Funktionen sinnvolle, nötige oder erforderliche elektrische, elektronische oder sonstige Bauteile.

Ein derartiges elektronisches Bauteil kann beispielsweise auch in dem Hohlraum untergebracht werden, in dem die Spule angeordnet wird. Dieses Bauteil kann horizontal, also parallel zur Außenseite der Leiterplatte, oder auch vertikal eingebracht werden. Dies kann unabhängig von der einzusetzenden Spule, also vorkonfektioniert, erfolgen. Es ist ebenfalls möglich, dass dieses zusätzliche Bauelement auf der einzusetzenden Spule angeordnet, also mit dieser verbunden ist.

Es ist ebenfalls möglich und wird von der Erfindung vorgeschlagen, dass ein zusätzliches elektronisches Bauelement unabhängig von einer einzusetzenden Spule direkt in einer Schicht einer Multilayerleiterplatte eingebracht wird.

Insbesondere kann in Weiterbildung der Erfindung vorgesehen sein, dass in einem Hohlraum mehrere Spulen angeordnet sind, die vorzugsweise übereinander geschichtet sind. Diese Spulen können getrennt elektrisch mit Leiterbahnen der Leiterplatte verbunden sein, oder auch zusammenwirken.

Insbesondere kann in Weiterbildung vorgesehen sein, dass mehrere für einen Hohlraum bestimmte Spulen miteinander verpresst sind, so dass sie ein einziges Bauteil bilden, das sich dann als ein Element verarbeiten und in den Hohlraum der Leiterplatte einsetzen lässt.

Eine weitere Möglichkeit besteht darin, dass eine einzelne Faltflex Spule mehrere getrennte Spulen aufweist, die durch ein entsprechendes Layout auf der Folie verwirklicht sind, bevor diese gefaltet wird. Natürlich sind auch Kombinationen möglich, wonach Faltflex Einrichtungen mit mehreren Spulen miteinander verpresst sind.

Erfindungsgemäß kann vorgesehen sein, dass es sich bei der Leiterplatte auch um eine Multilayerleiterplatte handelt, insbesondere dann, wenn weitere Funktionen in dem Induktionsbauteil untergebracht werden sollen.

Erfindungsgemäß kann in Weiterbildung vorgesehen sein, dass das Induktionsbauteil einen diskreten oder auch einen gedruckten Ferritkern für die Spule aufweist.

Es wurde bereits erwähnt, dass das Induktionsbauteil gegebenenfalls auch ein weiteres elektronisches Bauteil enthalten kann. Erfindungsgemäß kann in Weiterbildung vorgesehen sein, ein solches Bauteil nicht nur in einem Hohlraum der Leiterplatte unterzubringen, sondern auch an einer Außenlage der Leiterplatte.

Es ist andererseits auch möglich, ein weiteres Bauteil an einer Innenlage unabhängig von dem Hohlraum für die Spule anzuordnen.

Die Anordnung eines Bauteils an einer Innenlage kann entweder eine diskrete Bestückung mit dem Bauteil sein, oder auch einen Aufdrucken eines solchen Bauteils.

Die Zusammenfassung mehrerer Spulen durch Verpressen zur Bildung eines einzelnen handhabbaren Bestandteils eines Induktionsbauteils nach der Erfindung kann auch derart geschehen, dass diesem Bauteil ein Ferritkern hinzugefügt wird, so dass wiederum ein einzeln handhabbares Bestandteil zum Einsetzen in einen Hohlraum der Leiterplatte entsteht.

Der Ferritkern, bei dem es sich beispielsweise um einen Ringkern, oder auch um einen U-Kern oder einen E-Kern handeln kann, kann so angeordnet werden, dass er auf beiden Seiten aus den Spulen herausragt und auch aus der zusammengefügten Leiterplatte.

Andererseits ist es aber auch möglich, einen Ferritkern so anzuordnen, dass er beim Verschließen des Hohlraums durch Laminieren ebenfalls vollständig innerhalb der Leiterplatte angeordnet ist.

In Weiterbildung der Erfindung kann vorgesehen sein, dass eine Faltflex als elektronisches Bauteil mit Induktivitätsanteil und/oder Kapazitätsanteil und/oder Widerstandsanteil ausgebildet ist. Somit kann das Induktionsbauteil ein Element aufweisen, das als Induktivität, Kapazität und/oder Widerstand alleine oder auch in Kombination mit der Bedruckung beziehungsweise Bestückung verwendet werden kann.

Das Verfahren zum Herstellen eines solchen Induktionsbauteils läuft so ab, dass in die Kernschicht eines Stücks Leiterplatte ein Hohlraum eingebracht wird. In diese Ausnehmung wird die Spule oder ein Paket von Spulen eingebracht. Anschließend wird die Ausnehmung dadurch verschlossen, dass beidseits ein Prepreg und anschließend eine metallische Deckschicht auflaminiert wird. Die elektrisch leitende Verbindung kann dann in bekannter Weise erfolgen.

Falls die Leiterplatte beidseits mit einer metallischen Deckschicht versehen ist, kann diese metallische Deckschicht auf einer Seite oder auf beiden Seiten vorher entfernt werden. Das Entfernen der Deckschicht kann beispielsweise in einem Arbeitsgang mit der Herstellung der Ausnehmung erfolgen, die nach Herstellung einen Hohlraum in der Leiterplatte bildet.

Zur Anbringung eines Bauelements auf einer Innenlage, beispielsweise sogar einer Innenlage einer Spule, kann vorgesehen sein, dass auf einer mit Spulenwindungen bedruckten Folie vor deren Falten die weiteren Bauteile angebracht werden, entweder durch eine Vorbestückung oder durch ein Aufdrucken.

Einen Ferritkern, der mehreren Spulen gemeinsam sein soll, kann beispielsweise vor dem Einbringen der Spulen in den Hohlraum der Leiterplatte mit diesen verbunden werden.

Weitere Merkmale, Einzelheiten und Vorzüge der Erfindung ergeben sich aus den Ansprüchen und der Zusammenfassung, deren beider Wortlaut durch Bezugnahme zum Inhalt der Beschreibung gemacht wird, der folgenden Beschreibung bevorzugter Ausführungsformen der Erfindung sowie anhand der Zeichnung. Hierbei zeigen:
- Figur 1: einen Schnitt durch eine Leiterplatte vor ihrer Bearbeitung;
- Figur 2: den Schnitt durch die Leiterplatte nach Herstellung eines Hohlraums;
- Figur 3: schematisch zwei verschieden große Faltflex Spulen;
- Figur 4: die Anordnung einer Faltflex Spule in dem Hohlraum;
- Figur 5 den: Schnitt durch die Leiterplatte nach ihrer Kontaktierung;
- Figur 6: einen Schnitt durch eine Leiterplatte mit Kontakten und zwei Hohlräumen;
- Figur 7: einen der Figur 4 entsprechenden Schnitt bei der Ausführungsform der Figur 6;
- Figur 8: den Schnitt der Figur 7 nach Laminierung der in Figur 7 noch getrennten Schichten;
- Figur 9: das endgültige Ergebnis der Bearbeitung der Ausführungsform nach den Figuren 6 bis 8;
- Figur 10: das Ergebnis einer Bearbeitung einer Leiterplatte mit zwei Prepregschichten;
- Figur 11: einen Schnitt durch eine gegenüber der Leiterplatte der Figur 10 geänderte Ausführungsform;
- Figur 12: eine Ausführungsform mit durch die Leiterplatte durchgehenden Öffnungen;
- Figur 13: der Ausführungsform der Figur 12 mit eingesetztem Ferritkern;
- Figur 14: die Ausführungsform der Figur 12 und 13 nach Fertigstellung mit zusätzlichen Bauteilen;
- Figur 15: zwei Faltflex Spulen mit vorher eingesetztem Ferritkern;
- Figur 16: eine den Figuren 4 und 7 entsprechende Darstellung mit den Spulen der Figur 15;
- Figur 17: eine Faltflex Spule mit seitlich angebrachten weiteren Bauelementen;
- Figur 18: eine mit Spulenwindungen versehene Folie mit aufgesetzten Bauelementen;
- Figur 19: die durch das Falten der Folie der Figur 18 hergestellte Faltflex Spule;
- Figur 20: schematisch einen Schnitt durch eine Leiterplatte mit den Spulen der Figur 17 und Figur 19.

Ausgangspunkt für die Herstellung des Induktionsbauteils nach der Erfindung ist eine übliche Leiterplatte mit einer Kernschicht 1 und zwei metallischen Deckschichten 2. Zunächst werden die Deckschichten 2 entfernt, so dass nur die Kernschicht 1 übrig bleibt. In diese Kernschicht 1 wird ein Hohlraum 3 eingebracht, die im dargestellten Beispiel von der einen Seite zu der anderen Seite der Kernschicht 1 durchgeht.

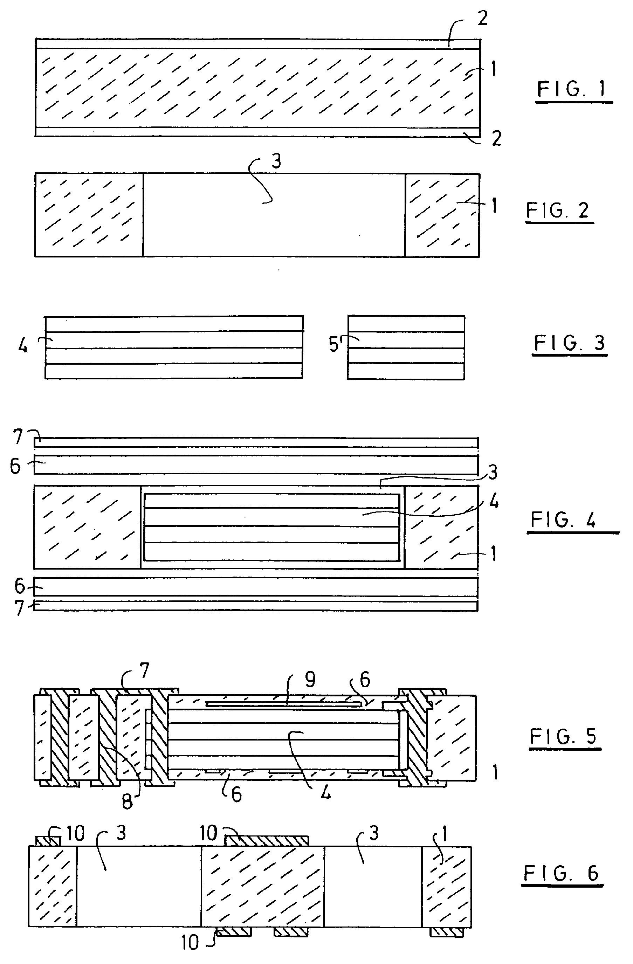

In Figur 3 sind zwei Faltflex Spulen 4, 5 dargestellt. Es ist angedeutet, dass diese aus mehreren Lagen gefalteter Folie mit Spulenwindungen aufgebaut sind. Diese Faltflex Spulen sind bekannt, sie können unterschiedliche Größen, Formen und unterschiedliche Werte aufweisen.

Die in Figur 3 links dargestellte Faltflex Spule 4 wird nun in den Hohlraum 3 der Kernschicht 1 eingesetzt. Von beiden Seiten wird dann eine Prepregschicht 6 und eine metallische Deckschicht 7 aufgelegt und mit der Kernschicht 1 laminiert.

Dann werden die metallischen Deckschichten 7 auf beiden Seiten durch die dazwischenliegenden Schichten hindurch mit durchkontaktierten Bohrungen miteinander verbundenen, wobei diese durchgehenden Leitungen 8 auch durch die Faltflex Spule 4 hindurch gehen und diese kontaktieren. Dies ist in Figur 5 dargestellt. Es ist hier auch zu sehen, dass in der Prepregschicht 6 auch ein zusätzliches Bauteil 9 eingebaut sein kann. Figur 5 zeigt das Endergebnis des gerade beschriebenen Verfahrens, nämlich ein Induktionsbauteil, das als in sich abgeschlossenes Stück einer Leiterplatte ausgebildet ist und jetzt in diesem Zustand beispielsweise mit einer anderen Leiterplatte elektrisch und mechanisch verbunden werden kann. Es ist auch denkbar und möglich, dass ein solches Induktionsbauteil Teil einer größeren Leiterplatte ist, in der weitere Funktionen enthalten sind.

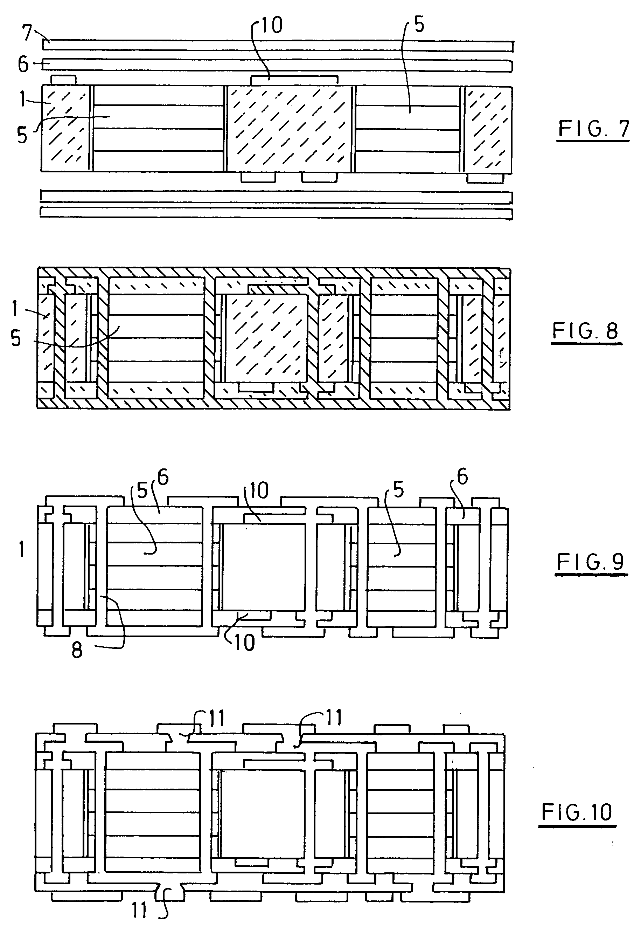

Die Figur 6 zeigt einen Verfahrensschritt bei einem anderen Herstellungsverfahren, bei dem nach dem in Figur 2 dargestellten Verfahrensschritt, diesmal mit zwei Hohlräumen 3, zunächst ein Leiterplattenlayout 10 auf den beiden Seitenflächen der Kernschicht aufgebracht wird. Anschließend werden in die beiden Hohlräume 3 jeweils eine Faltflex Spule 5 eingesetzt. Danach werden wieder die beiden Seitenflächen der Kernschicht 1 mit einer Prepregschicht 6 und einer metallischen Deckschicht 7 laminiert. Dadurch entsteht ein Zwischenprodukt, das in Figur 8 dargestellt ist. Es gibt hier also zwei Ebenen von Leiterbahnen auf jeder Seite der Kernschicht. Nun kann auf der äußeren metallischen Deckschicht 7 wiederum ein Leiterplattenlayout ausgebildet werden, so dass die in Figur 9 im Schnitt dargestellte Anordnung entsteht. Auch hier handelt es sich um ein Induktionsbauteil mit zwei Faltflex Spulen, die durch quer durch die Leiterplatte hindurch gehende Leiterbahnen 8 und das Leiterplattenelement auf beiden Seiten elektrisch verbunden sind.

Bei den nur schematisch angedeuteten Faltflex Spulen 4, 5 kann es sich auch um Pakete von Spulen handeln, bei denen mehrere Spulen miteinander verpresst sind, so dass sie als ein einziges Bauteil erscheinen und in dieser Weise in Hohlräume eingesetzt werden können.

Bei dem Induktionsbauteil, das in Figur 10 dargestellt ist, sind die Herstellungsvorgänge im einzelnen nicht dargestellt, da sie im Prinzip genauso ablaufen wie bei den vorher genannten Ausführungsformen. Es gibt in diesem Beispiel auf jeder Seite der ursprünglichen Kernschicht drei Ebenen von möglichen Leiterbahnen. Die Verbindung von der äußeren Ebene zu der mittleren Ebene geschieht durch Mikrovias 11.

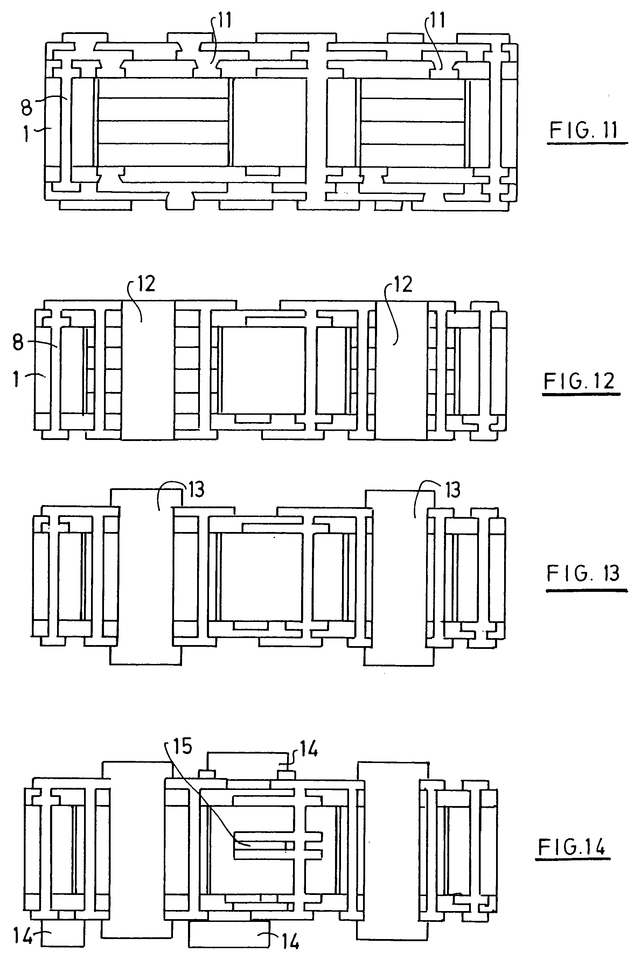

Während bei den in den Figuren 9 und 10 dargestellten Ausführungsformen die quer durch die Leiterplatte hindurch gehenden Verbindungen 8 durch die Spulen beziehungsweise Spulenpakete 5 hindurch gehen, zeigt die Figur 11 eine Ausführungsform, bei der die Ankontaktierung der Spulen nicht durch durch sie hindurch gehende Querverbindungen geschieht, sondern mithilfe von Leiterbahnkontaktierungen von den Flachseiten der Spulenpakete her, beispielsweise durch die Mikrovias 11 in der Figur 11.

Figur 12 zeigt eine weitere Ausführungsform, bei der in ein schon weitgehend hergestelltes Induktionsbauteil durchgehende Ausnehmungen 12 eingebracht werden, in die dann Ferritkerne 13 eingesetzt werden, siehe Figur 13.

Die Figur 14 zeigt, dass auf den Außenlagen der Leiterplatte zusätzliche elektronische Bauteile 14 aufgesetzt werden können, die auch funktionell mit dem Induktionsbauteil verbunden sind. Zusätzlich sind in Zwischenlagen innerhalb der Kernschicht noch weitere elektronische Bauteile 15 enthalten.

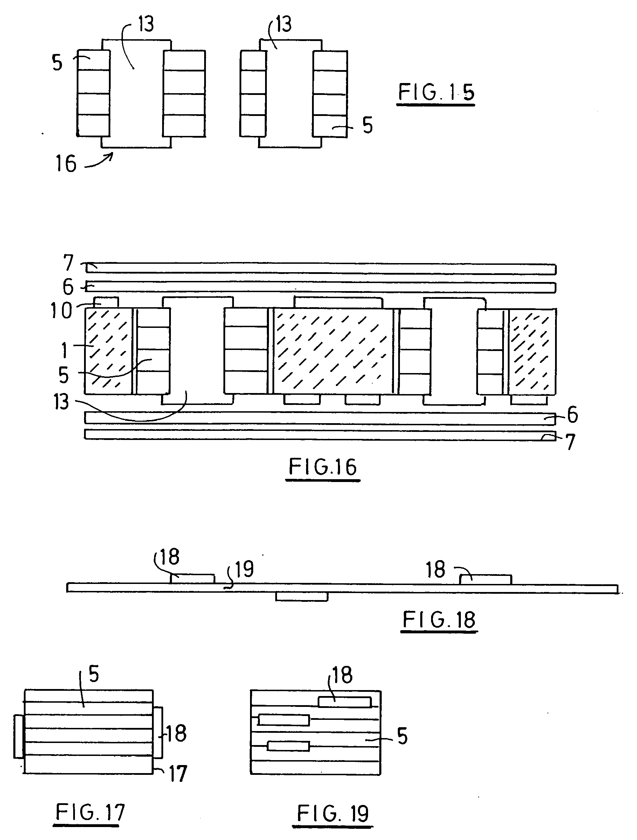

Bei der Ausführungsform, die in den Figuren 12 bis 14 dargestellt ist, werden die Ferritkerne 13 nachträglich eingefügt. In dem dargestellten Endergebnis, siehe Figur 14, sind dann die Enden der Ferritkerne 13 von der Außenseite des Induktionsbauteils her zugänglich. Es ist aber auch möglich, bei der Herstellung von miteinander verpressten Faltflex Spulen zur Bildung eines als einzelnes Element handhabbaren Bauteils gleich einen Ferritkern 13 mit einzufügen, entweder als diskreten Ferritkern oder als gedruckten Ferritkern. Dies ist in Figur 15 schematisch dargestellt. Dann kann in den Hohlraum 3 der Kernschicht 1 ein solches Bauelement 16 eingesetzt werden. Anschließend erfolgt wieder eine Verpressung mit einer Prepregschicht 6 und einer metallischen Deckschicht 7 auf beiden Seiten. Die weitere Behandlung entspricht dann dem, was bislang geschildert wurde.

Die Figur 17 zeigt ein Bauteil aus miteinander verpressten Faltflex Spulen 4, an dessen beiden Umfangsseiten 17 jeweils ein elektronisches Bauteil 18 angebracht ist, dessen Erstreckung also quer zu der Fläche der Kernschicht beziehungsweise Leiterplatte verläuft.

Es ist ebenfalls möglich, zusätzliche elektronische Bauelemente zwischen den Lagen einer Faltflex Spule anzuordnen. Dies ist schematisch in Figur 18 dargestellt. Ausgangspunkt für eine Faltflex Spule ist eine Folie 19 mit aufgedruckten oder in sonstiger Weise angeordneten Spulenwindungen, die in einem bestimmten Rapport angeordnet sind, so dass nach dem Falten dann die Spulenwindungen übereinander liegen. Auf diese Ausgangsfolie 19 können elektronische Bauelemente 18 angebracht werden, beispielsweise auch als diskrete Bauteile, oder aufgedruckt. Nach dem Falten, siehe Figur 19, liegen diese Bauteile 18 dann innerhalb der Faltflex Spule, gegebenenfalls auch an unterschiedlichen Stellen innerhalb dieser Spule.

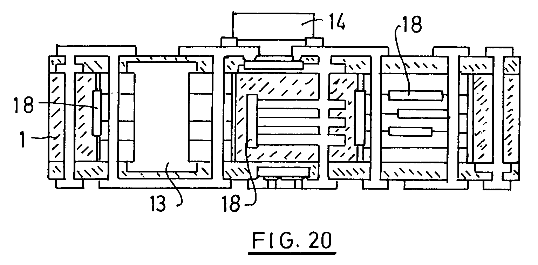

Figur 20 zeigt nun ein Induktionsbauteil, bei dem die unterschiedlichen bisher beschriebenen Möglichkeiten miteinander kombiniert sind. Hier sind zusätzliche elektronische Bauteile 18 innerhalb der Leiterplatte angeordnet, die entweder mit einer Faltflex Spule verbunden sind, oder aber auch unabhängig von der Faltflex Spule und unabhängig von einem Hohlraum in der Zwischenlage angebracht sind, wie beispielsweise in der Mitte dargestellt.

## Patentansprüche

1. Induktionsbauteil, beinhaltend
1.1 eine Leiterplatte,
1.2 mindestens einem in der Leiterplatte ausgebildeten Hohlraum (3),
1.3 mindestens einer in diesem Hohlraum (3) angeordneten Spule (4, 5), die
1.4 mit Leiterbahnen der Leiterplatte elektrisch leitend verbunden ist, wobei
1.5 der Hohlraum (3) auf beiden Seiten der Leiterplatte geschlossen ist.

2. Induktionsbauteil nach Anspruch 1, bei dem mindestens eine Spule als Faltflex- Spule (4, 5) ausgebildet ist.

3. Induktionsbauteil nach Anspruch 1 oder 2, bei dem mindestens eine Spule als Planarspule ausgebildet ist.

4. Induktionsbauteil nach einem der vorhergehenden Ansprüche, bei dem die Leiterplatte weitere Bauteile (9, 15, 18) enthält.

5. Induktionsbauteil nach einem der vorhergehenden Ansprüche, bei dem ein weiteres elektronisches Bauteil(18) in dem Hohlraum (3) angeordnet ist, in dem die Spule untergebracht ist.

6. Induktionsbauteil nach einem der vorhergehenden Ansprüche, bei dem in dem Hohlraum (3) mehrere Spulen angeordnet sind, die vorzugsweise übereinander geschichtet sind.

7. Induktionsbauteil nach einem der vorhergehenden Ansprüche, bei dem mehrere Spulen miteinander verpresst und zu einem Bauelement (16) zusammengefasst sind.

8. Induktionsbauteil nach einem der vorhergehenden Ansprüche, mit mindestens einem diskreten Ferritkern (13).

9. Induktionsbauteil nach einem der vorhergehenden Ansprüche, mit mindestens einem gedruckten Ferritkern (13).

10. Induktionsbauteil nach einem der vorhergehenden Ansprüche, mit mindestens einem weiteren auf der Außenlage angebrachten Bauelement (14).

11. Induktionsbauteil nach einem der vorhergehenden Ansprüche, bei dem eine Innenlage der Leiterplatte mit mindestens einem Bauelement (15) bestückt ist.

12. Induktionsbauteil nach einem der vorhergehenden Ansprüche, bei dem auf mindestens eine Innenlage ein Bauelement gedruckt ist.

13. Induktionsbauteil nach einem der vorhergehenden Ansprüche, mit mindestens einem mehrere Spulen durchsetzenden und mit diesen verpressten Ferritkern (13).

14. Induktionsbauteil nach Anspruch 13, bei dem mindestens ein Ferritkern (13) auf mindestens einer Außenseite der Leiterplatte nach außen ragt.

15. Induktionsbauteil nach Anspruch 13 oder 14, bei dem mindestens ein Ferritkern (13) beidseits vollständig von der Leiterplatte abgedeckt ist.

16. Induktionsbauteil nach einem der vorhergehenden Ansprüche, bei dem die Leiterplatte eine Multilayerleiterplatte ist.

17. Induktionsbauteil nach einem der vorhergehenden Ansprüche, bei dem eine Faltflex als elektronisches Bauteil mit Induktivitätsanteil und/oder Kapazitätsanteil und/oder Widerstandsanteil ausgebildet ist.

18. Verfahren zum Herstellen eines Induktionsbauteils, mit folgenden Verfahrensschritten:
18.1 in eine Kernschicht (1) einer Leiterplatte wird ein Hohlraum (3) eingebracht,
18.2 in den Hohlraum (3) wird eine vorher hergestellte Spule (4, 5) eingesetzt,
18.3 die Leiterplatte wird auf der/den Seite(n) der Öffnung des Hohlraums (3) mit einer Prepregschicht (6) und einer metallischen Deckschicht (7) laminiert,
18.4 zur Kontaktierung der Spulenwindungen werden Vias oder durchgehende Kontaktierungsmittel (8) eingebracht und an der Außenseite der Leiterplatte kontaktiert.

19. Verfahren nach Anspruch 18, bei dem die Kontaktierung der Spule (4, 5) von der Innenseite des Hohlraums (3) und/oder von der Außenseite der Leiterplatte aus erfolgt.

20. Verfahren nach Anspruch 18 oder 19, bei dem ausgehend von einer beidseits beschichteten Leiterplatte auf mindestens einer Seite die metallische Deckschicht (2) entfernt wird.

21. Verfahren nach einem der Ansprüche 18 bis 20, bei dem ein Bauelement (18) vertikal eingebracht wird.

22. Verfahren nach einem der Ansprüche 18 bis 21, bei dem auf mindestens einer Innenlage ein Bauelement (15) angebracht wird.

23. Verfahren nach einem der Ansprüche 18 bis 22, bei dem auf mindestens einer Außenlage ein Bauelement (14) angebracht wird.

24. Verfahren nach einem der Ansprüche 18 bis 23, bei dem mehrere Spulen zur Bildung eines Bauelements (16) miteinander verpresst werden.

25. Verfahren nach einem der Ansprüche 18 bis 24, bei dem ein Ferritkern (13) in die Leiterplatte eingebracht wird.

26. Verfahren nach einem der Ansprüche 18 bis 25, bei dem ein Ferritkern (13) in miteinander verbundene Spulen eingebracht und anschließend in den Hohlraum (3) der Leiterplatte eingesetzt wird.

27. Verfahren nach einem der Ansprüche 18 bis 26, bei dem miteinander verbundene Spulen mit weiteren Bauteilen (18) vorbestückt und anschließend in den Hohlraum (3) eingesetzt werden.

28. Verfahren nach einem der Ansprüche 18 bis 27, bei dem eine mit Spulenwindungen bedruckte Folie (19) vor dem Falten mit weiteren Bauteilen (18) vorbestückt und/oder bedruckt wird.

29. Verfahren nach einem der Ansprüche 18 - 28, bei dem eine Multilayerleiterplatte verwendet wird.

## Claims

1. Induction component, including
1.1 a circuit board,
1.2 at least one cavity (3) in the circuit board,
1.3 at least one coil (4, 5) disposed within said cavity (3),
1.4 said coil being electrically connected to conductor paths of the circuit board, wherein
1.5 the cavity (3) is closed on both sides of the circuit board.

2. Induction component according to claim 1, wherein at least one coil is a Foldflex (Faltflex) coil (4, 5).

3. Induction component according to claim 1 or 2, wherein at least one coil is a planar coil.

4. Induction component according to any one of the preceding claims, wherein the circuit board includes further components (9, 15, 18).

5. Induction component according to any one of the preceding claims, wherein a further electronic component (18) is disposed within the cavity (3) in which the coil is accommodated.

6. Induction component according to any one of the preceding claims, wherein a plurality of coils is disposed within the cavity (3), preferably are stacked one upon the other.

7. Induction component according to any one of the preceding claims, wherein a plurality of coils are pressed together and combined to one device (16).

8. Induction component according to any one of the preceding claims, having at least one discrete ferrite core (13).

9. Induction component according to any one of the preceding claims, having at least one printed ferrite core (13).

10. Induction component according to any one of the preceding claims, having at least one further device (14) attached on the outer layer.

11. Induction component according to any one of the preceding claims, wherein an inner layer of the circuit board is assembled with at least one device (15).

12. Induction component according to any one of the preceding claims, wherein a device is printed on at least one inner layer.

13. Induction component according to any one of the preceding claims, having at least one ferrite core (13) traversing a plurality of coils and pressed therewith.

14. Induction component according to claim 13, wherein at least one ferrite core (13) projects outwards on at least one outer side of the circuit board.

15. Induction component according to claim 13 or 14, wherein at least one ferrite core (13) is covered by the circuit board completely on both sides.

16. Induction component according to any one of the preceding claims, wherein the circuit board is a multilayer circuit board.

17. Induction component according to any one of the preceding claims, wherein a Foldflex is an electronic component including an inductance portion and/or a capacitance portion and/or a resistance portion.

18. Method for the production of an induction component, comprising the following method steps:
18.1 producing a cavity (3) in a core layer (1) of a circuit board,
18.2 placing a pre-fabricated coil (4, 5) into the cavity (3),
18.3 laminating the circuit board with a pre-preg layer (6) and a metallic cover layer (7) on the one or more side(s) of the opening of the cavity (3),
18.4 producing vias or through contact connection means (8) and contacting them on the outer side of the circuit board in order to contact the coil windings.

19. Method according to claim 18, wherein said contacting of the coil (4, 5) is from the inner side of the cavity (3) and/or from the outer side of the circuit board.

20. Method according to claim 18 or 19, wherein using a circuit board coated on both sides, the metallic cover layer (2) is removed from at least one side.

21. Method according to any of claims 18 to 20, wherein a device (18) is placed in vertically.

22. Method according to any of claims 18 to 21, wherein a device (15) is attached on at least one inner layer.

23. Method according to any of claims 18 to 22, wherein a device (14) is attached on at least one outer layer.

24. Method according to any of claims 18 to 23, wherein a plurality of coils are pressed together to produce one device (16).

25. Method according to any of claims 18 to 24, wherein a ferrite core (13) is placed in the circuit board.

26. Method according to any of claims 18 to 25, wherein a ferrite core (13) is placed in interconnected coils and subsequently is inserted into the cavity (3) of the circuit board.

27. Method according to any of claims 18 to 26, wherein interconnected coils are pre-assembled with further components (18) and subsequently are inserted into the cavity (3).

28. Method according to any of claims 18 to 27, wherein a film (19) with printed-on coil windings is pre-assembled and/or printed with further components (18) prior to folding.

29. Method according to any of claims 18 to 28, wherein a multilayer circuit board is used.

## Revendications

1. Composant à induction, comportant
1.1 une carte de circuits,
1.2 au moins une cavité (3) formée dans la carte de circuits,
1.3 au moins une bobine (4, 5) disposée dans ladite cavité (3),
1.4 la bobine étant électriquement connectée avec des pistes conductrices de la carte de circuits,
1.5 dans lequel la cavité (3) est fermée sur deux côtés de la carte de circuits.

2. Composant à induction selon la revendication 1, sur lequel au moins une bobine est conçu en forme de bobine Faltflex (4, 5).

3. Composant à induction selon la revendication 1 ou 2, sur lequel au moins une bobine est conçu en forme de bobine planaire.

4. Composant à induction selon l'une quelconque des revendications précédentes, sur lequel la carte de circuits comprend d'autres composants (9, 15, 18).

5. Composant à induction selon l'une quelconque des revendications précédentes, sur lequel un autre composant électronique (18) est disposé dans la cavité (3) où la bobine est logée.

6. Composant à induction selon l'une quelconque des revendications précédentes, sur lequel une pluralité de bobines sont disposées dans la cavité (3), de préférence empilées l'une sur l'autre.

7. Composant à induction selon l'une quelconque des revendications précédentes, sur lequel une pluralité de bobines sont pressées ensemble et combinées dans un dispositif (16).

8. Composant à induction selon l'une quelconque des revendications précédentes, avec au moins un noyau de ferrite (13) discret.

9. Composant à induction selon l'une quelconque des revendications précédentes, avec au moins un noyau de ferrite (13) imprimé.

10. Composant à induction selon l'une quelconque des revendications précédentes, avec au moins un autre dispositif (14) attaché sur la couche extérieure.

11. Composant à induction selon l'une quelconque des revendications précédentes, sur lequel une couche intérieure de la carte de circuits est équipée d'au moins un dispositif (15).

12. Composant à induction selon l'une quelconque des revendications précédentes, sur lequel un dispositif est imprimé sur au moins une couche intérieure.

13. Composant à induction selon l'une quelconque des revendications précédentes, avec au moins un noyau de ferrite (13) traversant une pluralité de bobines et étant pressé ensemble avec lesquelles.

14. Composant à induction selon la revendication 13, sur lequel au moins un noyau de ferrite (13) fait saillie vers l'extérieur au moins sur un côté extérieur de la carte de circuits.

15. Composant à induction selon la revendication 13 ou 14, sur lequel au moins un noyau de ferrite (13) est recouvert de la carte de circuits complètement de part et d'autre.

16. Composant à induction selon l'une quelconque des revendications précédentes, sur lequel la carte de circuits est une carte de circuits à plusieurs couches.

17. Composant à induction selon l'une quelconque des revendications précédentes, sur lequel une Faltflex est conçue en tant que composant électronique avec une proportion d'inductance et/ou une proportion de capacitance et/ou une proportion de résistance.

18. Procédé destiné à fabriquer un composant à induction, avec les étapes de procédé suivantes :
18.1 on fabrique une cavité (3) dans une couche de coeur (1) d'une carte de circuits,
18.2 on place une bobine (4, 5) préfabriquée dans la cavité (3),
18.3 on lamine la carte de circuits d'une couche de prépreg (6) sur l'un ou les côté(s) de l'aperture de la cavité (3) et d'une couche supérieure métallique (7),
18.4 on fabrique des vias ou des moyens de contact traversants (8) et les contacte sur le côté extérieur de la carte de circuits pour contacter les enroulements de bobine.

19. Procédé selon la revendication 18, dans lequel ledit procédé de contacter la bobine (4, 5) se fait du côté intérieur de la cavité (3) et/ou du côté extérieur de la carte de circuits.

20. Procédé selon la revendication 18 ou 19, dans lequel à partir d'une carte de circuits recouverte sur deux faces on enlève la couche supérieure métallique (2) au moins d'une face.

21. Procédé selon l'une quelconque des revendications 18 à 20, dans lequel on place un dispositif (18) verticalement.

22. Procédé selon l'une quelconque des revendications 18 à 21, dans lequel on attache un dispositif (15) sur au moins une couche intérieure.

23. Procédé selon l'une quelconque des revendications 18 à 22, dans lequel on attache un dispositif (14) sur au moins une couche extérieure.

24. Procédé selon l'une quelconque des revendications 18 à 23, dans lequel on presse une pluralité de bobines ensemble pour former un dispositif (16).

25. Procédé selon l'une quelconque des revendications 18 à 24, dans lequel on place un noyau de ferrite (13) dans la carte de circuits.

26. Procédé selon l'une quelconque des revendications 18 à 25, dans lequel on place un noyau de ferrite (13) dans des bobines interconnectées et ensuite on l'introduit dans la cavité (3) de la carte de circuits.

27. Procédé selon l'une quelconque des revendications 18 à 26, dans lequel on préfabrique des bobines interconnectées avec d'autres composants (18) et ensuite on les introduit dans la cavité (3).

28. Procédé selon l'une quelconque des revendications 18 à 27, dans lequel on préfabrique et/ou imprime une feuille (19) portant des enroulements de bobine imprimés là-dessus avec d'autres composants (18) avant le pliage.

29. Procédé selon l'une quelconque des revendications 18 à 28, dans lequel on utilise une carte de circuits à plusieurs couches.
